# EUROPÄISCHE PATENTSCHRIFT

(11) **EP 3 214 912 B1**
(45) Veröffentlichungstag und Bekanntmachung des Hinweises auf die Patenterteilung: **12.12.2018**
(21) Anmeldenummer: 17000319.8
(22) Anmeldetag: 27.02.2017
(51) Int. Cl.: H05K 7/20

(54) **VORRICHTUNG UND VERFAHREN ZUM KÜHLEN ELEKTRISCHER UND ELEKTRONISCHER KOMPONENTEN**
DEVICE AND METHOD FOR COOLING OF ELECTRIC AND ELECTRONIC COMPONENTS
DISPOSITIF ET PROCÉDÉ DE REFROIDISSEMENT DE COMPOSANTS ÉLECTRIQUES ET ÉLECTRONIQUES

(30) Priorität: 03.03.2016 DE 202016001447 U
(43) Veröffentlichungstag der Anmeldung: 06.09.2017
(73) Patentinhaber: Runge, Andre, 17489 Greifswald (DE)
(72) Erfinder: Runge, Andre, 17489 Greifswald (DE)
(74) Vertreter: Kietzmann, Manfred

(56) Entgegenhaltungen:
- US-A1- 2012 050 957
- US-A1- 2016 044 827

## Beschreibung

Die Erfindung betrifft das Kühlen von elektrischen und elektronischen Komponenten und daraus bestehenden Installationen, die sich im Betriebszustand erwärmen, was zu Leistungsverlusten, Ausfällen und zur Verkürzung der Lebensdauer führen kann.

Die Erfindung betrifft dabei gehauste Räume, insbesondere Schränke, Gehäuse, Kabinen oder Kästen, die zur Aufnahme der elektronischen und/oder elektrischen Komponenten und Installation verwendet werden.

In der Praxis finden dabei geschlossene Systeme und offene Systeme Verwendung.

Der Einsatz von geschlossenen Systemen (Wärmetauscher) ist Aufgrund der konstruktiv begrenzten Größe und der gesetzlichen vorgegebenen Emissionsgrenzwerte oft nur bedingt möglich. Geschlossene Systeme bieten jedoch den Vorteil, dass z. B. der Elektroschrank hohe IP-Schutzgrade (International Protection Code) erreicht und weitestgehend bis hermetisch abgeschlossen sein kann. Die angesaugte kühlende Luft trifft somit nicht in den Kontakt mit der inneren Luft des Schrankes, wodurch eine geringe Staub- und Partikelbelastung erreicht wird.

Bei offenen Systemen (Gebläselüftung) wird Umgebungsluft durch den Innenraum des z. B. Elektroschrankes geblasen oder gesaugt, was entwärmungstechnisch effektiv ist, aber sich ohne geeignete Maßnahmen schädlich auf die Komponenten, Baugruppen und Installation im Elektroschrank auswirken kann, da sie einer erhöhten Staub- und Partikelbelastung ausgesetzt sind.

Aus der DE 198 33 247 C2 ist eine Schutzabdeckung eines Gebläsekühlaggregats für feuchtigkeitsempfindliche Bauteile zur Abdeckung von Lufteintritts- oder -austrittsöffnungen des Gebläsekühlaggregats bekannt, wobei die Schutzabdeckung ein wasserdichtes, luftdurchlässiges, poröses Material mit einer Porengröße im Bereich von 0,5 bis 20 µm umfaßt.

Das poröse Material ist bevorzugt ein textiles Flächengebildet oder insbesondere eine Membran. Als Membranmaterial kommen synthetische Polymere zum Einsatz. Als textile Flächengebilde kommen Gewebe, Gewirke oder Vliese in Betracht.

Einfacher ausgedrückt, kommen Filter zum Einsatz. Das oder die Gebläse befinden sich dabei in Durchströmrichtung hinter den elektronischen Bauteilen und vor den Austrittsöffnungen.

Gemeinsam ist diesem und weiterem Stand der Technik, dass der Wärmeaustrag aus dem gekapselten Raum über die zwangsweise durch den Raum geführte Luft erfolgt, somit eine aktive Klimatisierungskomponente verwendet wird, die es aus Umwelt-, Investition- und energetischen Gründen weitestgehend zu vermeiden gilt.

Darüber hinaus sind Vorrichtungen bekannt, die die Kühlung über Konvektion vorsehen.

So beschreibt die US 2016/0044827 A1 eine elektronische Vorrichtung mit eine Abdeckung für eine oder mehrere wärmeerzeugende Komponenten, wobei die Abdeckung zumindest eine kombinierte leitfähige, konvektive und strahlende Kühlung für die wärmeerzeugenden Komponenten bereitstellt, während die Vorrichtung innerhalb eines vorgeschriebenen Temperaturbereichs gehalten wird. Leitendes Kühlen wird realisiert, indem eine thermische Kopplung zwischen jedem von zwei oder mehr Vertiefungsbereichen in der Abdeckung und einer oder mehreren wärmeerzeugenden Komponenten vorgesehen wird. Eine geeignete Anordnung von Lufteinlässen und -auslässen durch die Abdeckung sorgt für eine konvektive Kühlung der wärmeerzeugenden Komponenten und der thermisch gekoppelten Vertiefungsbereiche.

Aus der US 2012/0050957 A1 ist eine elektronische Vorrichtung bekannt, die eine Solarabschirmung aufweist. Die Solarabschirmung hat einen Befestigungsabschnitt, der an der elektronischen Vorrichtung befestigt ist, und einen Abschirmungsabschnitt, der mit dem Befestigungsabschnitt verbunden ist. Der Schildabschnitt verhindert, dass direktes Sonnenlicht im Wesentlichen einen Abschnitt der elektronischen Vorrichtung erreicht. Der Abschirmungsabschnitt definiert mindestens einen Teil eines Lufteinlasses, mindestens einen Teil eines Luftauslasses und mindestens einen Teil eines Luftdurchlasses, der sich von dem Lufteinlass zu dem Luftauslass erstreckt. Der Luftdurchgang liegt über dem Abschnitt der elektronischen Vorrichtung, so dass Umgebungsluft neben dem Lufteinlass eine natürliche Konvektionsluftströmung in den Lufteinlass und aus dem Luftauslass durch den Luftdurchgang ausbildet, um während des elektronischen Betriebs Wärme von dem Abschnitt der elektronischen Vorrichtung abzuführen.

Aufgabe der Erfindung ist es, die Leistungsfähigkeit einer Vorrichtung zum Kühlen elektrischer und elektronischer Komponenten zu erhöhen, die auf aktive Klimatisierungskomponenten verzichtet.

Gelöst wird diese Aufgabe mit den Merkmalen des Vorrichtungsanspruches 1 und des Verfahrensanspruches 12. Vorteilhafte Ausgestaltungen sind Gegenstand der Unteransprüche.

Bei einem Gehäuse für sich erwärmende elektrische und elektronische Komponenten und Installationen, das Gehäusewandungen aufweist, die die Komponenten und Installation einkapseln, und aus dem Wärme austragbar ist, um eine Temperierung der Komponenten und Installationen vorzunehmen, indem mindestens ein Abschnitt der Gehäusewandungen aus einer gewebeartigen luftdurchlässigen Struktur besteht, dessen Wärmedurchgang durch das Material der gewebeartigen Struktur größer oder gleich ist wie die Wärmediffusion der die Struktur durchdringenden Luft bei gleichem Innen- und Außendruck auf die Gehäusewandungen, wird erfindungsgemäß vorgeschlagen, dass mindestens eine Gehäusewandung oder ein Abschnitt einer Gehäusewandung als Doppelwandung ausgebildet ist, wobei die äußere und die innere Gehäusewandung unter Bildung eines Raumes beabstandet zueinander angeordnet sind und mindestens die innere Gehäusewandung die gewebeartige luftdurchlässige Struktur aufweist.

Das bedeutet, dass der Wärmeaustausch zwischen dem sich durch die Wärmeabstrahlung der elektrischen und elektronischen Komponenten und Installationen erwärmenden Gehäuseinnenraum und der Außenumwelt zumindest über eine gewissen Zeitraum durch Wärmediffusion und Konvektion erfolgen kann, somit ohne eine aktive kostenverursachende Klimatisierungskomponente.
Dabei besteht Spielraum in der Größe der mit der gewebeartigen Struktur versehenen Gehäusewandung. Es kann sich um einen Ausschnitt der Gehäusewandung handeln, um eine vollständige Gehäusewandung oder auch mehrere Gehäusewandungen.

Durch die Wärmediffusion tritt die Wärme aus dem Gehäuse in den Raum zwischen den beiden Gehäusewandungen aus. Ein solcher Raum bietet die Möglichkeit, die austretende Wärme beschleunigt abzuführen (Kamineffekt), was die Wärmediffusion ebenfalls beschleunigt.

Die gewebeartige luftdurchlässige Struktur ist bevorzugt ein Gewebe aus Metallfäden, Kunststofffäden und/oder Textilfäden.

Vorteilhaft ist es dabei, wenn am und/oder in dem Gewebe und/oder um das Gewebe herum eine Stützstruktur, vorzugsweise aus Metall, angeordnet ist, so dass das Gewebe z.B. bei einem Elektroschrank eine gute Lagestabilität aufweist.

Der durch die Doppelwandung gebildete Raum besitzt bei einer Ausführung mindestens oben und unten Öffnungen oder ist vollständig offen. Dadurch wird eine natürliche Luftströmung entlang der gewebeartigen luftdurchlässigen Struktur erzeugt (Kamineffekt), was die Wärme aus der Wärmediffusion beschleunigt abführt.

Bei einer anderen Ausführung öder gleichzeitig mit der vorgenannten verfügt der durch die Doppelwandung gebildete Raum über mindestens eine Einlassöffnung für in den Raum einblasbare Luft und über Auslassöffnungen. Möglich sind auch Einlassöffnungen und mindestens eine Auslassöffnung zum Absaugen von im Raum befindlicher Luft.

Vorteilhafterweise sind die mindestens eine Einlassöffnung und die Auslassöffnungen an unterschiedlichen Seiten des Raumes angeordnet, vorzugsweise an gegenüberliegenden.

Das Einblasen und Absaugen erfolgt mittels eines Lüfters, der bevorzugt temperaturabhängig von einem Messsensor im Gehäuse steuerbar ist.

Auch bei diesen Ausführungen wird somit nahezu völlig auf eine aktive kostenverursachende Klimatisierungskomponente verzichtet.

Soll generell das Eindringen von Partikeln, Staub oder Feinstaub oder auch Flüssigkeitströpfchen in das Gehäuse verhindert werden, sieht eine Ausgestaltung vor, dass das Gehäuse über eine Lufteinlassöffnung verfügt, über die gefilterte Luft in das Gehäuse einblasbar ist. Durch den so erzeugten leichten Überdruck wird deren Eindringen in das Gehäuse ausgeschlossen.

Da die gewebeartige Struktur luftdurchlässig ist, tritt somit auch Luft aus dem Gehäuse aus und damit zusätzlich Wärme. Dieser Effekt kann auch genutzt werden, wenn die eingangs benannte Wärmediffusion an Grenzen stößt.

Das vorgeschlagene Kühlsystem verfügt somit über verschiedene Steigerungsformen der Kühlung ohne eine aktive Klimakomponente und impliziert als "letzte Möglichkeit" auch die Kühlung mit einer aktiven Klimakomponente.

Die vorgeschlagene Vorrichtung zum Kühlen elektrischer und elektronischer Komponenten soll anhand von Ausführungsbeispielen erläutert werden.

Es zeigen:
- Fig. 1: Wärmedurchgang durch das Material der luftdurchlässigen Struktur,
- Fig. 2: Wärmedurchgang durch das Material der und Wärmetransport durch die luftdurchlässige Struktur bei gleichem Innen- und Außendruck und
- Fig. 3: Wärmedurchgang durch das Material der und Wärmetransport durch die luftdurchlässige Struktur bei erhöhtem Innendruck.

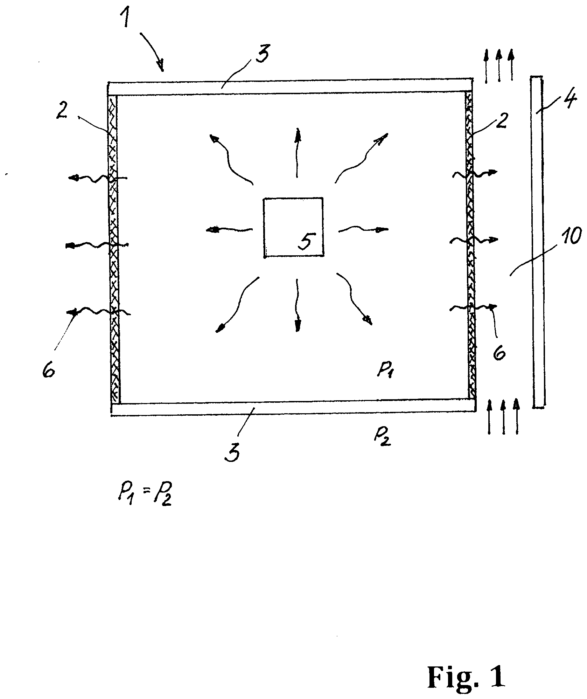

**Fig. 1** zeigt ein Gehäuse 1 mit sich erwärmenden elektrischen und elektronischen Komponenten 5 und Installationen. Das Gehäuse 1 weist Gehäusewandungen 2, 3 auf, die die Komponenten 5 und Installationen einkapseln. Aus dem Gehäuse 1 ist Wärme austragbar, um eine Temperierung der Komponenten 5 und der Installationen vorzunehmen, indem zwei Gehäusewandungen 2 aus einer gewebeartigen luftdurchlässigen Struktur bestehen, wobei das Material der gewebeartigen Struktur einen so geringen thermischen Widerstand und einen so hohen Wärmeübergangswert aufweist, das der Wärmedurchgang 6 durch das Material der gewebeartigen Struktur größer oder gleich ist wie der Wärmetransport 7 durch die die Struktur durchdringende Luft bei gleichem Innen- und Außendruck (P₁ = P₂) auf die Gehäusewandungen 2, 3. Der Wärmeaustausch zwischen dem sich durch die Wärmeabstrahlung der elektrischen und elektronischen Komponenten 5 und Installationen erwärmenden Gehäuseinnenraum und der Außenumwelt erfolgt somit zumindest über eine gewissen Zeitraum durch Wärmediffusion und Konvektion, also ohne eine aktive kostenverursachende Klimatisierungskomponente.

Die Luftdurchlassfähigkeit der Gehäusewandungen 2 ist in diesem Fall minimal eingerichtet.

Eine Gehäusewandung 2 -hier rechts- ist als Doppelwandung ausgebildet, wobei die äußere 4 und die innere 2 Gehäusewandung unter Bildung eines Raumes 10 beabstandet zueinander angeordnet sind und die innere Gehäusewandung 2 die gewebeartige luftdurchlässige Struktur aufweist.

Der durch die Doppelwandung 2, 4 gebildete Raum 10 ist oben und unten offen, so dass der Wärmeaustrag aus dem Raum 10 durch eine Wärmezirkulation erreicht wird.

Die Gehäusewandungen 2 bestehen aus einer gewebeartigen luftdurchlässigen Struktur, hier aus einem Gewebe aus Metallfäden. Um das Gewebe herum ist eine Stützstruktur für das Gewebe aus Metall angeordnet, d.h. das Gewebe ist in die Stützstruktur, z.B. einen Rahmen, eingespannt, wobei der Rahmen gegenüber den anderen Wandungen 3 abgedichtet angeordnet ist. Die notwendige Festigkeit z. B. bei einer Wandung eines Schaltschrankes wird so ebenso wie das Design gewährleistet.

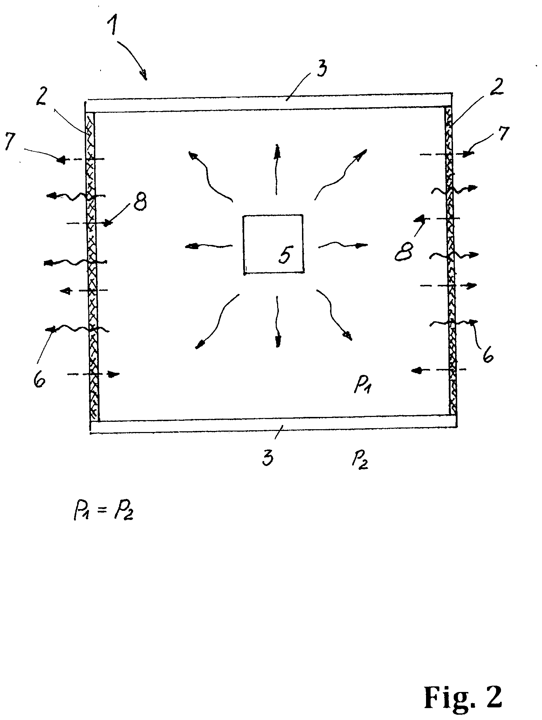

**Fig. 2** zeigt eine analoge Ausführung wie **Fig. 1**, wobei hier die Luftdurchlässigkeit durch die luftdurchlässige Struktur der Gehäusewandung 2 höher ist. Neben dem Wärmedurchgang 6 durch das Material der luftdurchlässigen Struktur findet auch ein Wärmetransport 7 durch die die luftdurchlässige Struktur durchdringende Luft statt. Im Gegenzug dringt von außen auch kühle Luft in das Gehäuse 1 durch die luftdurchlässige Struktur ein.

Natürlich ist es auch bei dieser Ausführung möglich, ein oder mehrere Gehäusewandungen 2 oder auch Abschnitte doppelwandig auszuführen. Öffnungen oben und unten in den so gebildeten Raum sorgen bevorzugt für einen zügigen Abtransport der nach außen geleiteten Wärme.

Auch diese Ausführung kommt ohne aktive kostenverursachende Klimatisierungskomponente aus. Beachtet werden muss bei dieser Ausführung jedoch, dass je nach Umfang der Luftdurchlässigkeit auch Staub, insbesondere Feinstaub aus der Umgebung mit in das Gehäuse 1 gelangen kann, dargestellt als Außenluft 8.

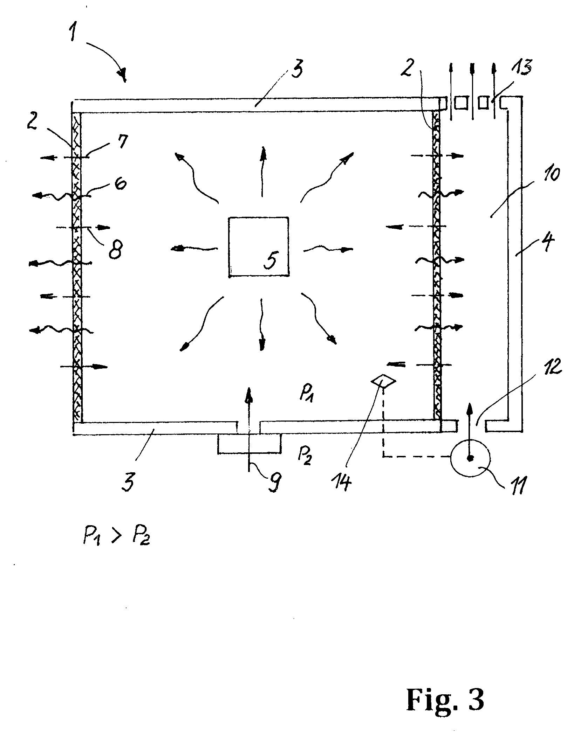

Soll der Staubeintrag unterbunden werden, kann von der Ausführung gemäß **Fig. 3** Gebrauch gemacht werden. Hier wurde außen am Gehäuse 1 ein Lüfter angeordnet, der gefilterte Luft 9, bevorzugt Außenluft, in das Gehäuse 1 bläst. Dadurch baut sich ein geringer Überdruck im Gehäuse 1 auf, der das Einströmen von Außenluft 8 durch die luftdurchlässige Struktur der Gehäusewandung 2 unterbindet und damit auch den Staubeintrag.

Diese Ausführung lässt es auch zu, dass bei extremer Erwärmung des Innenraumes des Gehäuses 1 die Leistung des Lüfters zum Einblasen von gefilterter Luft 9 erhöht wird und damit die Strömung von erwärmter Innenluft durch die luftdurchlässige Struktur nach außen.

Der vorhandene Wärmedurchgang 6 durch das Material der luftdurchlässigen Struktur bleibt davon im Wesentlichen unbeeinflusst.

Weiter wird eine weitere Möglichkeit des Wärmeaustrags aus dem Raum 10 gezeigt. Der durch die Doppelwandung 2, 4 gebildete Raum 10 verfügt über eine Einlassöffnung 12 für in den Raum 10 einblasbare Luft und über Auslassöffnungen 13. Die eine Einlassöffnung 12 und die Auslassöffnungen 13 sind an unterschiedlichen Seiten des Raumes 10 angeordnet, vorzugsweise an gegenüberliegenden.

Das Einblasen von Außenluft erfolgt gesteuert durch einen Lüfter 11, der temperaturabhängig von einem Messsensor 14 im Gehäuse 1 steuerbar ist. Auf diese Weise wird die durch das Material der Gehäuswandung 2 durchdiffundierte Wärme schneller abgeführt.

Mit den vorgeschlagenen Ausführungen erfolgt das Kühlen gehauster elektrischer und elektronischer Komponenten 5 und Installationen kostenoptimiert und ökologisch Vorteilhaft.

### Bezugszeichenliste

- 1: Gehäuse
- 2: Gehäusewandung mit luftdurchlässiger Struktur
- 3: Gehäusewandung
- 4: weitere Gehäusewandung
- 5: sich erwärmende elektrische Komponente
- 6: Wärmedurchgang durch das Material der luftdurchlässigen Struktur
- 7: Wärmetransport durch die die luftdurchlässige Struktur durchdringende Luft
- 8: Außenluft
- 9: gefilterte Luft
- 10: Raum
- 11: Lüfter
- 12: Einlassöffnung
- 13: Auslassöffnung
- 14: Messsensor

## Patentansprüche

1. Vorrichtung zum Kühlen von sich erwärmenden elektrischen und elektronischen Komponenten (5) und Installationen in einem Gehäuse (1), wobei das Gehäuse (1) Gehäusewandungen (2, 3) aufweist, die die Komponenten (5) und Installationen einkapseln, und wobei aus dem Gehäuse (1) Wärme austragbar ist, indem mindestens ein Abschnitt der Gehäusewandungen (2) aus einer gewebeartigen luftdurchlässigen Struktur besteht, dessen Wärmedurchgang (6) durch das Material der gewebeartigen Struktur größer oder gleich ist wie die Wärmediffusion (7) der die Struktur durchdringende Luft bei gleichem Innen- und Außendruck (P₁ = P₂), **dadurch gekennzeichnet, dass**
mindestens eine Gehäusewandung (2) oder ein Abschnitt einer Gehäusewandung (2) als Doppelwandung ausgebildet ist, wobei die äußere (4) und die innere (2) Gehäusewandung unter Bildung eines Raumes (10) beabstandet zueinander angeordnet sind und mindestens die innere Gehäusewandung (2) die gewebeartige luftdurchlässige Struktur aufweist, wobei die Wärme aus dem Raum (10) beschleunigt abführbar ist.

2. Vorrichtung nach Anspruch 1, **dadurch gekennzeichnet, dass**
der durch die Doppelwandung (2, 4) gebildete Raum (10) vertikal verläuft und mindestens oben und unten offen ist oder hier Öffnungen aufweist.

3. Vorrichtung nach Anspruch 1, **dadurch gekennzeichnet, dass**
der durch die Doppelwandung (2, 4) gebildete Raum (10) über mindestens eine Einlassöffnung (12) für in den Raum (10) einblasbare Luft und über Auslassöffnungen (13) verfügt.

4. Vorrichtung nach Anspruch 1, **dadurch gekennzeichnet, dass**
der durch die Doppelwandung gebildete Raum (10) über Einlassöffnungen (12) und mindestens eine Auslassöffnung (13) zum Absaugen von im Raum (10) befindlicher Luft verfügt.

5. Vorrichtung nach Anspruch 3 oder 4, **dadurch gekennzeichnet, dass**
die mindestens eine Einlassöffnung (12) und die Auslassöffnungen (13) an unterschiedlichen Seiten des Raumes (10) angeordnet sind, vorzugsweise an gegenüberliegenden.

6. Vorrichtung nach Anspruch 3 oder 4, **dadurch gekennzeichnet, dass**
das Einblasen und Absaugen mittels eines Lüfters (11) erfolgt, der temperaturabhängig von einem Messsensor (14) im Gehäuse (1) bevorzugt steuerbar ist.

7. Vorrichtung nach einem der Ansprüche 1 bis 6, **dadurch gekennzeichnet, dass**
mindestens eine Gehäusewandung (2) aus einer gewebeartigen luftdurchlässigen Struktur besteht.

8. Vorrichtung nach einem der Ansprüche 1 bis 7, **dadurch gekennzeichnet, dass**
die gewebeartige luftdurchlässige Struktur ein Gewebe aus Metallfäden, Kunststofffäden und/oder Textilfäden ist.

9. Vorrichtung nach einem der Ansprüche 1 bis 8, **dadurch gekennzeichnet, dass**
am und/oder in dem Gewebe und/oder um das Gewebe herum eine Stützstruktur, vorzugsweise aus Metall, angeordnet ist.

10. Vorrichtung nach einem der Ansprüche 1 bis 9, **dadurch gekennzeichnet, dass**
das Gehäuse (1) über eine Lufteinlassöffnung verfügt, über die gefilterte Luft (9) in das Gehäuse (1) einblasbar ist, um durch einen Überdruck mindestens das Eindringen von Staub- und Feinstaubpartikeln in das Gehäuse (1) auszuschließen.

11. Verfahren zum Kühlen von sich erwärmenden elektrischen und elektronischen Komponenten (5) und Installationen in einem Gehäuse (1), wobei das Gehäuse (1) Gehäusewandungen (2, 3) aufweist, die die Komponenten (5) und Installationen einkapseln, und wobei aus dem Gehäuse (1) Wärme austragbar ist, indem mindestens ein Abschnitt der Gehäusewandungen (2) aus einer gewebeartigen luftdurchlässigen Struktur besteht und mindestens eine Gehäusewandung (2) oder ein Abschnitt einer Gehäusewandung (2) als Doppelwandung ausgebildet ist, wobei die äußere (4) und die innere (2) Gehäusewandung unter Bildung eines Raumes (10) beabstandet zueinander angeordnet sind und mindestens die innere Gehäusewandung (2) die gewebeartige luftdurchlässige Struktur aufweist, wobei
der Wärmedurchgang (6) durch das Material der gewebeartigen Struktur größer oder gleich ist wie die Wärmediffusion (7) durch die die Struktur durchdringende Luft bei gleichem Innen- und Außendruck (P₁ = P₂) auf die Gehäusewandungen (2, 3).

12. Verfahren nach Anspruch 11, **dadurch gekennzeichnet, dass**
die durch den Wärmedurchgang (6) durch das Material und den Wärmetransport (7) durch die die luftdurchlässige Struktur durchdringende Luft nach außerhalb des Gehäuses (1) gelangende Wärme zwangsweise abgeführt wird.

13. Verfahren nach Anspruch 12, **dadurch gekennzeichnet, dass**
die Innentemperatur des Gehäuses (1) gemessen wird und als Steuergröße für die zur zwangsweisen Wärmeabfuhr eingesetzten Mittel dient.

14. Verfahren nach einem der Ansprüche 11 bis 13, **dadurch gekennzeichnet, dass**
zur Verhinderung eines Staubeintrages in das Gehäuse (1) gefilterte Luft (9) in das Gehäuse (1) eingeblasen wird.

15. Verfahren nach Anspruch 14, **dadurch gekennzeichnet, dass**
das einblasbare Volumen der gefilterten Luft (9) steuerbar ist und als Leistungsreserve für die Erhöhung der Kühlung genutzt wird.

## Claims

1. A device for cooling electrical and electronic components (5) and installations which heat up in a housing (1), wherein the housing (1) has housing walls (2, 3) which encapsulate the components (5) and installations, and wherein heat is removable from the housing (1) in that at least one portion of the housing walls (2) consists of a woven fabric-like, air-permeable structure, which heat transmission (6) by the material of the woven fabric-like structure is greater than or equal to the heat diffusion (7) of the air penetrating the structure in the case of identical internal and external pressure (P1 = P2), **characterized in that**
at least one housing wall (2) or one portion of a housing wall (2) is formed as a double wall, the outer (4) and the inner (2) housing walls are arranged spaced from one another, forming a space (10), and **in that** at least the inner housing wall (2) has the woven fabric-like, air-permeable structure, wherein the heat is dissipatable at an accelerated rate out of the space (10).

2. The device according to Claim 1, **characterized in that**
the space (10) formed by the double wall (2, 4) extends vertically and is open at least at the top and bottom or has openings here.

3. The device according to Claim 1, **characterized in that** the space (10) formed by the double wall (2, 4) has at least one inlet opening (12) for air which can be blown into the space (10) and has outlet openings (13) .

4. The device according to Claim 1, **characterized in that**
the space (10) formed by the double wall has inlet openings (12) and at least one outlet opening (13) for extracting air located in the space (10).

5. The device according to Claim 3 or 4, **characterized in that**
the at least one inlet opening (12) and the outlet openings (13) are arranged on different sides of the space (10), preferably on opposing sides.

6. The device according to Claim 3 or 4, **characterized in that**
the blowing in and extraction take place by means of a fan (11) which is preferably controllable, independent of temperature, by a measuring sensor (14) in the housing (1).

7. The device according to any one of Claims 1 to 6, **characterized in that**
at least one housing wall (2) consists of a woven fabric-like, air-permeable structure.

8. The device according to any one of Claims 1 to 7, **characterized in that**
the woven fabric-like, air-permeable structure is a woven fabric of metal filaments, plastics filaments and/or textile filaments.

9. The device according to any one of Claims 1 to 8, **characterized in that**
a supporting structure, preferably of metal, is arranged on and/or in the woven fabric and/or around the woven fabric.

10. The device according to any one of Claims 1 to 9, **characterized in that**
the housing (1) has an air inlet opening via which filtered air (9) can be blown into the housing (1) in order, through overpressure, to rule out at least the penetration of dust and particulate matter into the housing (1).

11. A method for cooling electrical and electronic components (5) and installations which heat up in a housing (1), wherein the housing (1) has housing walls (2, 3) which encapsulate the components (5) and installations, and wherein heat is removable from the housing (1) in that at least one portion of the housing walls (2) consists of a woven fabric-like, air-permeable structure and in that at least one housing wall (2) or one portion of a housing wall (2) is formed as a double wall, wherein the outer (4) and inner (2) housing walls are arranged spaced from one another, forming a space (10), and at least the inner housing wall (2) has the woven fabric-like, air-permeable structure, wherein
the heat transmission (6) by the material of the woven fabric-like structure is greater than or equal to the heat diffusion (7) by the air penetrating the structure in the case of identical internal and external pressure (P1 = P2) on the housing walls (2, 3) .

12. The method according to Claim 11, **characterized in that**
the heat passing outside the housing (1) as a result of the heat transmission (6) by the material and the heat transfer (7) by the air penetrating the air-permeable structure is forcibly dissipated.

13. The method according to Claim 12, **characterized in that**
the internal temperature of the housing (1) is measured and used as a control variable for the means used for the forcible dissipation.

14. The method according to any one of Claims 11 to 13, **characterized in that**
filtered air (9) is blown into the housing (1) to prevent dust from entering the housing (1).

15. The method according to Claim 14, **characterized in that**
the volume of filtered air (9) which can be blown in is controllable and used as a reserve capacity for increasing the cooling.

## Revendications

1. Dispositif pour le refroidissement de composants électriques et électroniques (5) et d'installations se réchauffant dans un boîtier (1), le boîtier (1) présentant des parois de boîtier (2, 3), lesquelles enferment les composants (5) et les installations, et de la chaleur pouvant être évacuée hors du boîtier (1), par le fait qu'au moins une section des parois de boîtier (2) se compose d'une structure de type tissé perméable à l'air, dont le passage de chaleur (6) par le matériau de la structure de type tissé est supérieur ou égal à la diffusion thermique (7) de l'air traversant la structure pour des pressions intérieure et extérieure égales (P₁ = P₂),
**caractérisé en ce qu'**
au moins une paroi de boîtier (2) ou une section d'une paroi de boîtier (2) est formée comme paroi double, la paroi de boîtier extérieure (4) et la paroi de boîtier intérieure (2) étant disposées à distance l'une de l'autre en formant un espace (10), et au moins la paroi de boîtier intérieure (2) présentant la structure de type tissé perméable à l'air, la chaleur pouvant être dissipée de façon accélérée hors de l'espace (10).

2. Dispositif selon la revendication 1, **caractérisé en ce que**
l'espace (10) formé par la double paroi (2, 4) s'étend verticalement et est ouvert au moins en haut et en bas ou présente des ouvertures à ces emplacements.

3. Dispositif selon la revendication 1, **caractérisé en ce que**
l'espace (10) formé par la double paroi (2, 4) dispose d'au moins une ouverture d'admission (12) pour l'air pouvant être injecté dans l'espace (10) et d'ouvertures de sortie (13).

4. Dispositif selon la revendication 1, **caractérisé en ce que**
l'espace (10) formé par la double paroi (2, 4) dispose d'ouvertures d'admission (12) et d'au moins une ouverture de sortie (13) pour l'aspiration de l'air se trouvant dans l'espace (10) .

5. Dispositif selon la revendication 3 ou 4, **caractérisé en ce que**
l'au moins une ouverture d'admission (12) et les ouvertures de sortie (13) sont disposées sur des côtés différents de l'espace (10), de préférence sur des côtés opposés.

6. Dispositif selon la revendication 3 ou 4, **caractérisé en ce que**
l'injection et l'aspiration sont effectuées au moyen d'un ventilateur (11), lequel peut être commandé de préférence par un capteur de mesure (14) dans le boîtier (1), en fonction de la température.

7. Dispositif selon l'une des revendications 1 à 6, **caractérisé en ce qu'**
au moins une paroi de boîtier (2) se compose d'une structure de type tissé perméable à l'air.

8. Dispositif selon l'une des revendications 1 à 7, **caractérisé en ce que**
la structure de type tissé perméable à l'air est un tissu de fils métalliques, de fils en plastique et/ou de fils textiles.

9. Dispositif selon l'une des revendications 1 à 8, **caractérisé en ce qu'**
une structure support, de préférence en métal, est disposée contre et/ou dans le tissu et/ou autour du tissu.

10. Dispositif selon l'une des revendications 1 à 9, **caractérisé en ce que**
le boîtier (1) dispose d'une ouverture d'admission d'air, par laquelle de l'air filtré (9) peut être injecté dans le boîtier (1), afin d'empêcher par une surpression au moins la pénétration de particules de poussière et de particules de poussière fine dans le boîtier (1).

11. Procédé pour le refroidissement de composants électriques et électroniques (5) et d'installations se réchauffant dans un boîtier (1), le boîtier (1) présentant des parois de boîtier (2, 3), lesquelles enferment les composants (5) et les installations, et de la chaleur pouvant être évacuée hors du boîtier (1) par le fait qu'au moins une section des parois de boîtier (2) se compose d'une structure de type tissé perméable à l'air et au moins une paroi de boîtier (2) ou une section d'une paroi de boîtier (2) est formée comme paroi double, la paroi de boîtier extérieure (4) et la paroi de boîtier intérieure (2) étant disposées à distance l'une de l'autre en formant un espace (10), et au moins la paroi intérieure (2) présentant la structure de type tissé perméable à l'air,
le passage de chaleur (6) par le matériau de la structure de type tissé étant supérieur ou égal à la diffusion thermique (7) par l'air traversant la structure, pour des pressions intérieure et extérieure égales (P₁ = P₂) sur les parois de boîtier (2, 3).

12. Procédé selon la revendication 11, **caractérisé en ce que**
la chaleur parvenant hors du boîtier (1) par le passage de chaleur (6) par le matériau et par le transport de chaleur (7) par l'air traversant la structure perméable à l'air est évacuée de façon forcée.

13. Procédé selon la revendication 12, **caractérisé en ce que**
la température intérieure du boîtier (1) est mesurée et sert de grandeur de commande aux moyens utilisés pour l'évacuation forcée de la chaleur.

14. Procédé selon l'une des revendications 11 à 13, **caractérisé en ce que**
de l'air filtré (9) est injecté dans le boîtier (1) pour empêcher une pénétration de poussière dans le boîtier (1).

15. Procédé selon la revendication 14, **caractérisé en ce que**
le volume de l'air filtré (9) pouvant être injecté est contrôlable et est utilisé comme réserve de puissance pour l'augmentation du refroidissement.
